# EUROPEAN PATENT APPLICATION

(11) **EP 2 007 009 A2**
(43) Date of publication of application: **24.12.2008**
(21) Application number: 08252033.9
(22) Date of filing: 12.06.2008
(51) Int. Cl.: H03H 1/00, H03H 7/09, H03H 7/01, H03H 11/04, H01F 17/00, H05K 1/16, H01G 4/30

(54) **Planar emi filter**

(30) Priority: 15.06.2007 US 763638
(71) Applicant: City University of Hong Kong, Hong Kong (HK)
(72) Inventor: Hui, Shu Yuen Ron, New Territories, Hong Kong (HK); Lui, Xun, Guiyang, Guizhou Province (CN); Lee, Chi Kwan, New Territories, Hong Kong (HK)
(74) Representative: Martin, David John

(57) **Abstract**

An EMI filter for use between a power source and an electronic product is formed of at least one planar element comprising a pair of opposed coreless spiral planar windings, and a planar capacitor. This enables the integration of common mode and differential mode filters into integrated planar structures. Furthermore the planar EMI filter may be combined with an active filter element to provide a hybrid EMI filter comprising both passive and active elements with superior performance.

## Description

### FIELD OF THE INVENTION

This invention relates to a planar EMI filter, and in particular to such a filter suitable for use with ultra-high frequency power converters.

### BACKGROUND OF THE INVENTION

EMI filters are routinely provided with electrical and electronic devices to ensure that any electromagnetic noise generated by the device is not allowed to pass back into the mains power supply. Generally such filters are classed as being either differential mode (DM) filters comprising inductive elements in the live and neutral lines, or common mode (CM) filters comprising capacitive elements between the live and neutral lines and ground.

### PRIOR ART

Traditionally EMI filters are constructed by conventional circuit components including in particular discrete capacitive and inductive components provided on a circuit board. However, with increasing miniaturization of electronic components such EMI filters may become disproportionately large with respect to the associated circuits and components that are being filtered. There is therefore a need for more compact EMI filter designs, and in particular for EMI filters that can be integrated with other electronic components in an electronic device.

Known in the art are coreless planar spiral windings (CPSW) that may be used in coreless transformers. A CPSW may be formed in a number of ways, for example by depositing conductive tracks on a printed circuit board and when used in a coreless transformer for signal and/or power transfer primary and secondary windings may be formed as CPSWs on opposing sides of a suitable dielectric substrate. In addition to their use in coreless transformers for power and signal transfer, such planar spiral windings have also been proposed for use in integrated EMI filters with the help of ferrite materials. Coupled coreless planar spiral windings have also been proposed to cancel the capacitor parasitic inductance in traditional EMI filters. It has also been known to use CPSW as the inductive elements in differential mode EMI filters, but such prior proposals have always continued to use discrete three-dimensional capacitors that prevent complete integration of the EMI filter structure.

### SUMMARY OF THE INVENTION

According to the present invention there is provided an EMI filter for use between a power source and an electronic product, wherein the EMI filter comprises at least one planar element comprising a pair of opposed coreless spiral planar windings, and a planar capacitor.

Preferably the planar windings are formed on opposed sides of a substrate, such as for example a printed circuit board.

The planar capacitor may comprise at least two parallel conductive plates spaced apart by a dielectric material.

The filter is preferably a combined conductive mode filter and differential mode filter. In such an embodiment the conductive mode filter may comprise a first planar element, and the differential mode filter may comprises two planar elements symmetrically disposed in the phase and neutral lines between the power source and the product.

There are a number of possible configurations for such a combined common mode and differential mode filter.

For example, in some embodiments the common mode filter is provided adjacent the power source and the differential mode filter is provided adjacent the product. In these embodiments the planar capacitor may be provided between the common mode filter and the differential mode filter, or between the differential mode filter and the product, or between the power source and the common mode filter.

Alternatively the differential mode filter may be provided adjacent to the power source and the common mode filter may be provided adjacent to the product. In these embodiments the planar capacitor may be provided between the power source and the differential mode filter, or between the differential mode filter and the common mode filter, or between the common mode filter and the product.

According to one embodiment of the invention the planar windings are formed such that alternate rings of each of the spiral winding are formed on opposite sides of a substrate and are electrically interconnected by vias whereby each side of the substrate is formed with alternating rings belonging to the respective spiral windings.

Furthermore, preferably the planar EMI filter of embodiments of the invention may be combined with an active filter element that may be provided at the middle-stage, at the end-stage or at both the middle- and end-stage of the filter.

According to another aspect of the present invention therefore there is provided an EMI filter comprising a passive filter and an active filter wherein said passive filter comprises at least one planar element comprising a pair of opposed coreless spiral planar windings, and a planar capacitor.

### BRIEF DESCRIPTION OF THE DRAWINGS

Some embodiments of the present invention will now be described by way of example and with reference to the accompanying drawings, in which:-
FIG.1 shows schematically two coreless planar spiral windings and their equivalent circuit,
FIG.2 shows schematically the role of an EMI filter,
FIGS.3a and 3b illustrate two examples of the use of a coreless planar spiral winding as a direct mode filter,
FIG.4 shows an example of a planar capacitor as may be used in embodiments of the invention,
FIG.5 shows an example of a common mode filter according to an embodiment of the invention,
FIG.6 shows a conventional combined CM and DM EMI filter,
FIG.7 shows a combined CM and DM EMI filter according to an embodiment of the invention,
FIG.8 shows a combined CM and DM EMI filter according to another embodiment of the invention,
FIG.9 shows a combined CM and DM EMI filter according to another embodiment of the invention,
FIG.10 shows a combined CM and DM EMI filter according to another embodiment of the invention,

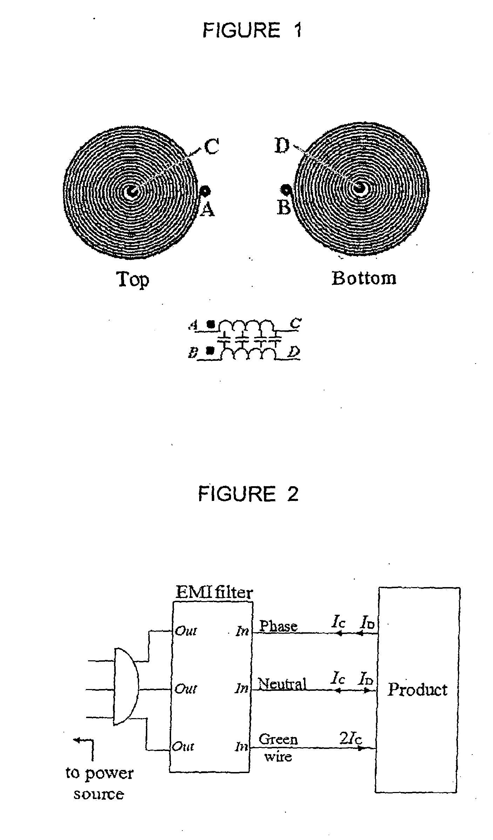

FIG.1 shows a combined CM and DM EMI filter according to another embodiment of the invention,

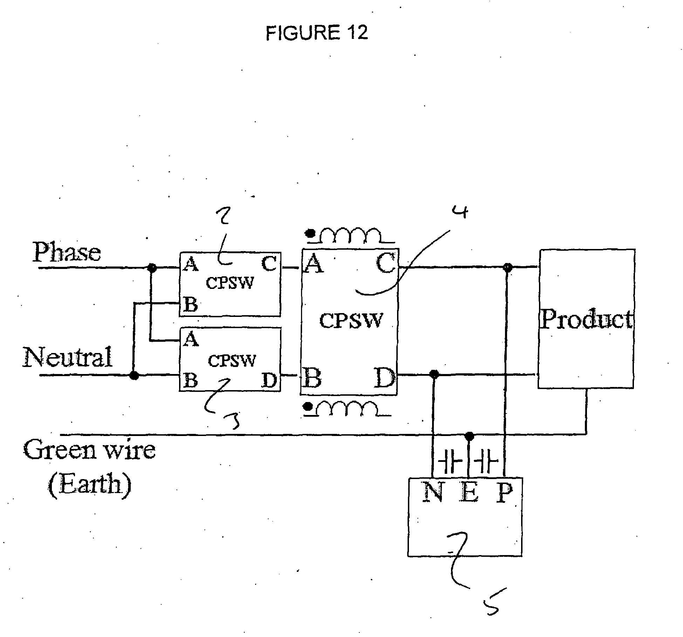

FIG.12 shows a combined CM and DM EMI filter according to another embodiment of the invention,

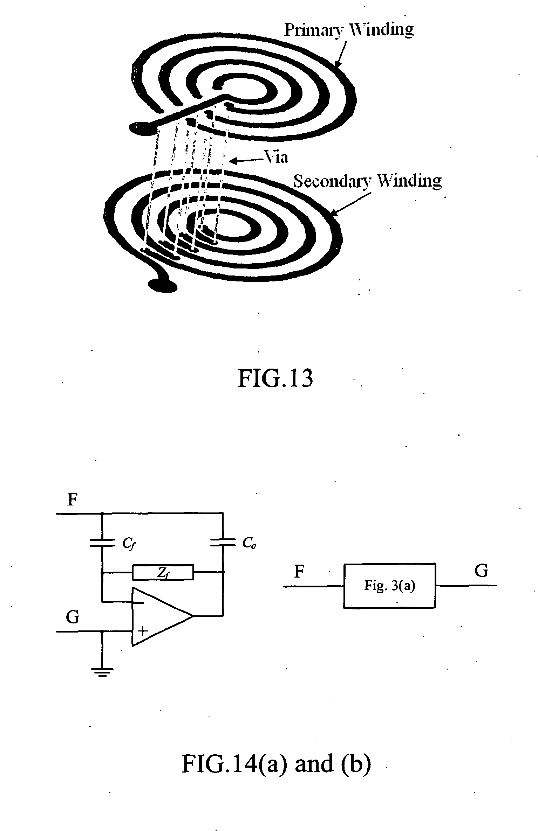

FIG.13 illustrates an alternating stacked winding structure for use in embodiments of the invention,
FIGS.14(a) and (b) illustrate one example of an active filter that may be combined with a planar EMI filter in accordance with further embodiments of the invention,

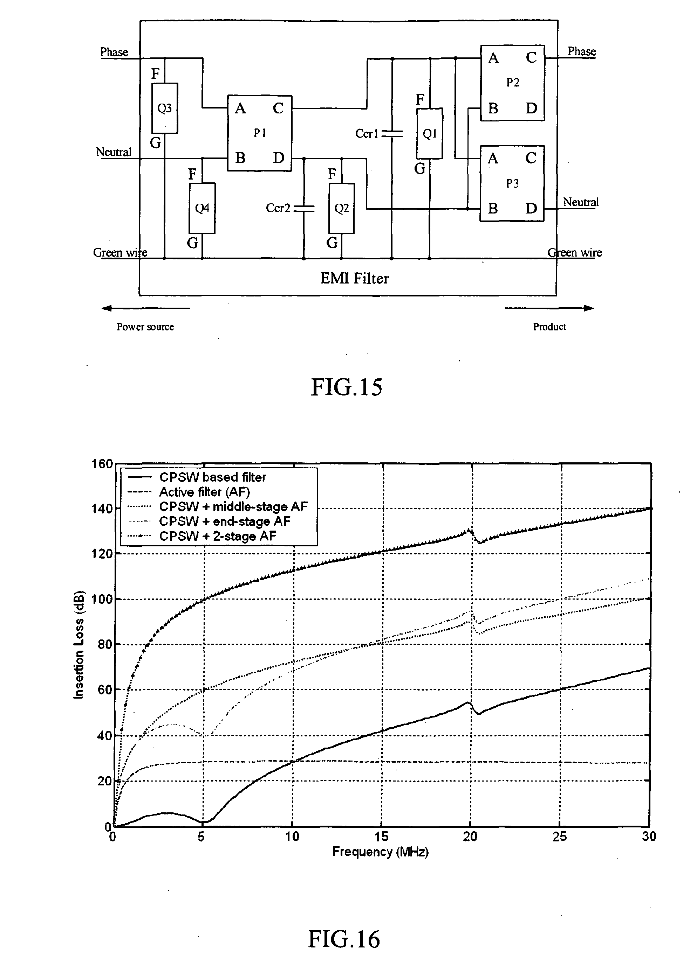

FIG.15 illustrates schematically a hybrid EMI filter comprising passive and active components according to an embodiment of the invention,
FIG.16 shows simulated common mode insertion losses for different hybrid filter configurations,

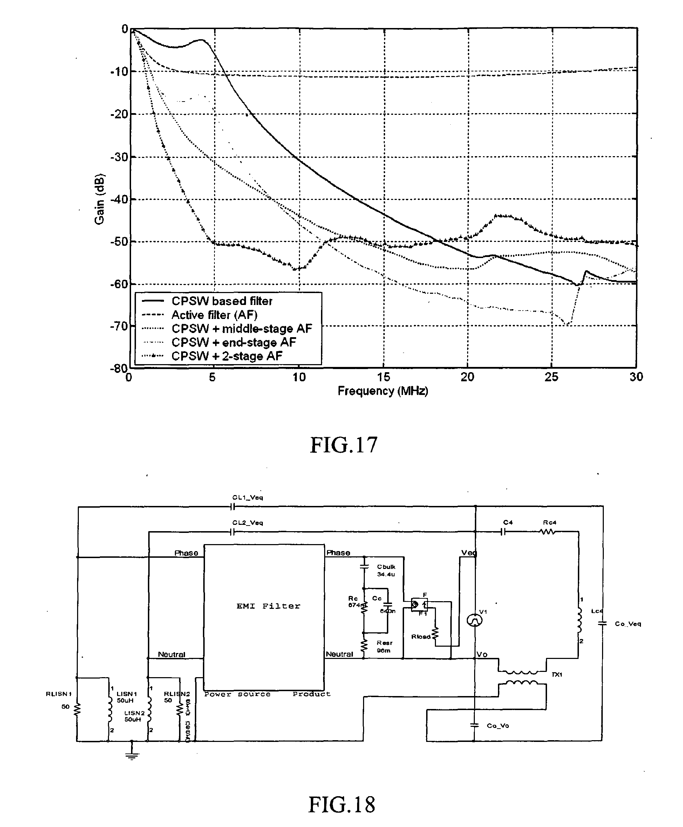

FIG.17 shows measured common mode transfer gains for different hybrid filter configurations,
FIG.18 shows a circuit schematic for use in complete EMI noise simulations, and

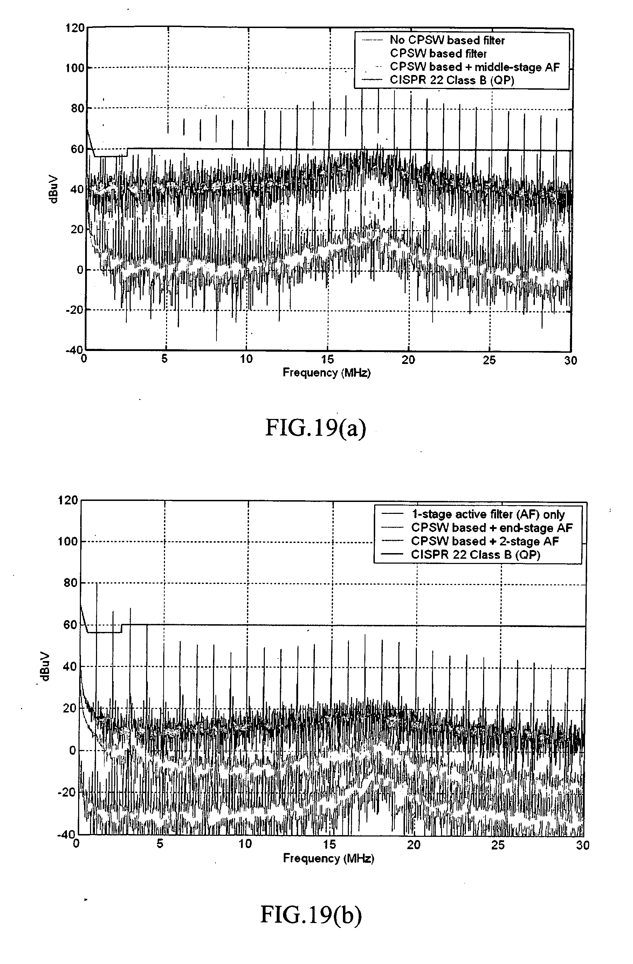

FIGS.19(a)-(c) show simulated EMI noise for different filter configurations.

### DETAILED DESCRIPTION OF PREFERRED EMBODIMENTS

FIG. shows two conventional spiral windings. The dimensions and number of turns of the windings may vary depending on the intended application. The windings can be constructed with printed circuit board (PCB) or other substrates such as semiconductor materials. For construction in the PCB, the windings may be formed on opposed sides of a PCB substrate, eg 0.4mm thick and may form the primary and secondary coils of a coreless transformer as is known in the art. For convenience of description throughout this specification the ends of the top coil may be labeled A and C, while the corresponding ends of the bottom coil may be labeled B and D. As shown in Fig.1, when placed on opposite sides of a substrate the two planar spiral windings may be represented electrically as two inductances with a capacitive component between them.

FIG.2 shows a simple block diagram of the function of an EMI filter. The function of the EMI filter is to block and/or divert the conducted emission current in common mode (I_{C}) and differential mode (I_{D}) so that they do not enter the power source.

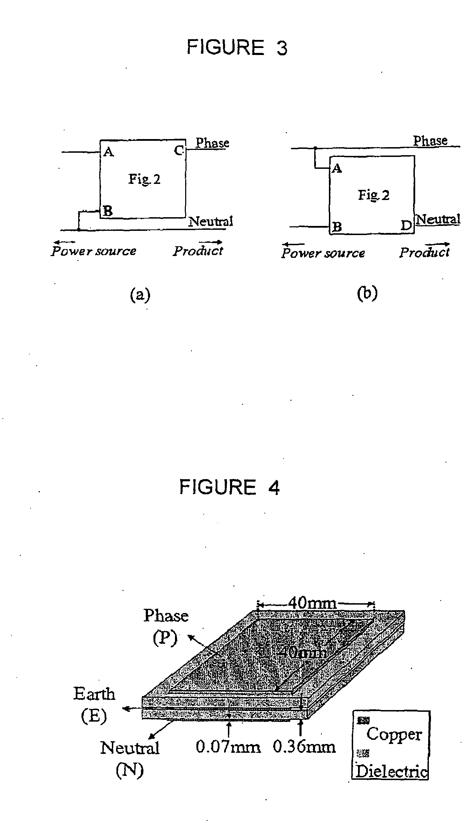

FIG.3a shows how two planar spiral windings formed on opposed sides of a substrate may be employed as a DM filter added on the phase line. Using the nomenclature of FIG.1 the phase line from the power source is connected at A and the phase line from the filter to the device goes from C. Point B is connected to earth. FIG.3b shows how the same windings can be employed as a DM filter added on the neutral line. In this example point A is connected alone to the phase line, while the neutral line from the power source is connected at point B and the neutral line goes from point D to the device.

An important aspect of the present invention, at least in preferred embodiments, is the integration of planar CM and DM filter elements with planar capacitive elements such that the complete filter structure can be more easily integrated in its own design and also with other circuit elements. In this connection embodiments of the invention may employ one or more planar capacitors an example of which is shown in FIG.4. As shown in FIG.4 this planar capacitor may comprise three planar copper layers in a sandwich-like structure and separated by dielectric layers. The three copper layers may respectively be connected to the phase, earth and neutral lines as may be required in any particular circuit diagrams. By way of example only, typical dimensions may be 40mm x 40mm x 0.07mm for the copper layers, and a thickness of 0.36mm for the interleaving dielectric layers. The dielectric material may be a simple PCB substrate, or may be a material of higher permittivity if a higher capacitance is required.

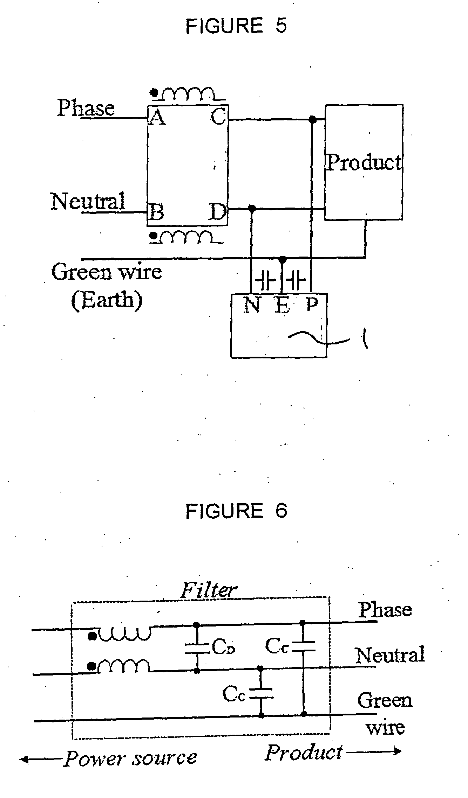

FIG.5 shows how a planar capacitor 1 may be used in conjunction with a planar spiral winding structure to form a common mode filter. The planar spiral windings are connected in the phase and neutral lines between the power source and the product with the phase line from the power source being connected at A and the phase line extending to the product from C. Similarly the neutral line from the power source is connected at B and the neutral line continues to the product from D. A planar capacitor 1 constructed as shown in Fig.4 is connected between the spiral windings and the product, with the neutral, phase and earth layers of the capacitor 1 being connected to the respective neutral, phase and earth lines.

The examples above show DM and CM filters separately, but preferably they may be combined in a single EMI filter. FIG.6 shows how this is done in a conventional EMI filter. A conventional combined filter normally consists of a CM choke as well as CM capacitors and a DM capacitor as shown in FIG.6. Such a conventional design can be looked at as a CM filter with a DM capacitor added, but when a CM choke is used in a DM filter only a very small leakage inductance remains effective for filtering because of flux cancellation and so a large capacitor C_{D} is needed to achieve the required filtering effect. Providing such a large capacitance in a planar capacitor structure as shown in FIG.4 requires either an undesirably large area, or a dielectric material of high permittivity.

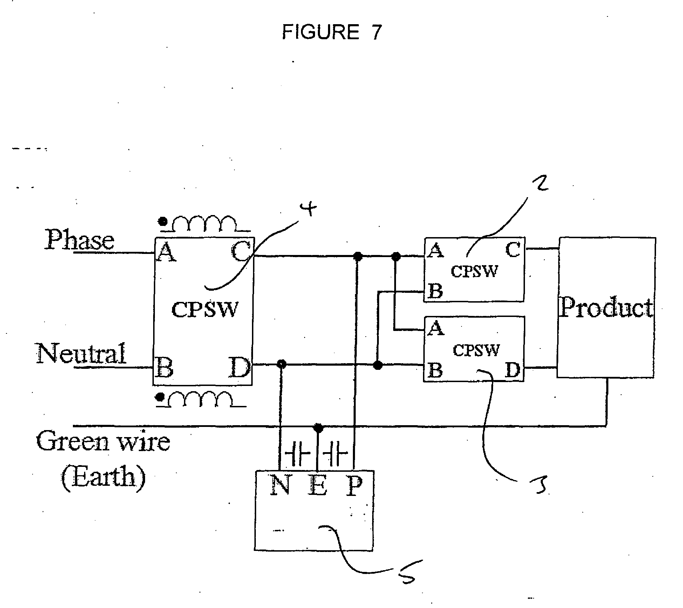

FIG.7 shows a combined CM and DM filter using planar spiral windings and planar capacitors that mitigates this problem. In this embodiment two DM filters 2,3 respectively of the forms shown in FIG.3a and FIG.3b and with filter 2 added to the phase line and filter 3 added to the neutral line. These two DM filters provide the DM EMI filtering while retaining filter circuit symmetry. CM filtering is provided by CM filter 4 which is of the form shown in FIG.5 including the planar capacitor 5. It will be noted that terminal C in the CM filter - which is in the phase line - connects to terminals A in both the DM filters, while terminal D in the CM filter - which is in the neutral line - connects to terminals B in the DM filters. One advantage of this circuit design is that the capacitive elements in the CM filter - both the planar capacitor and the distributed capacitance in the spiral windings - contributes to the overall DM filtering.

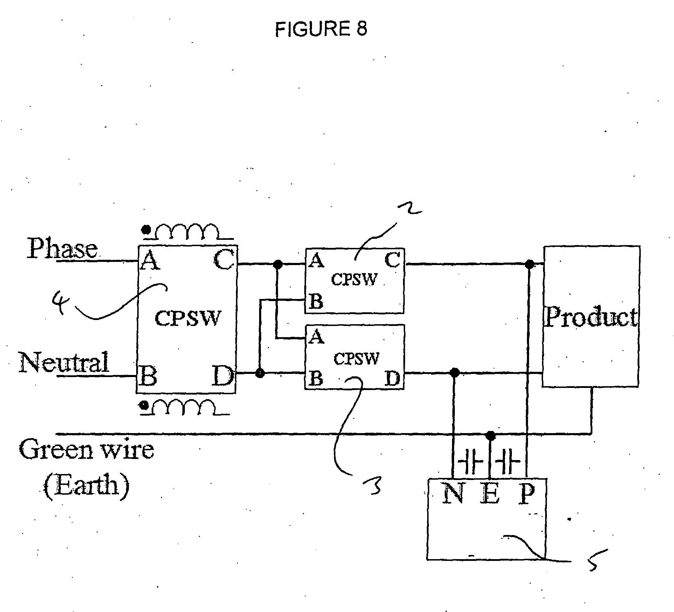

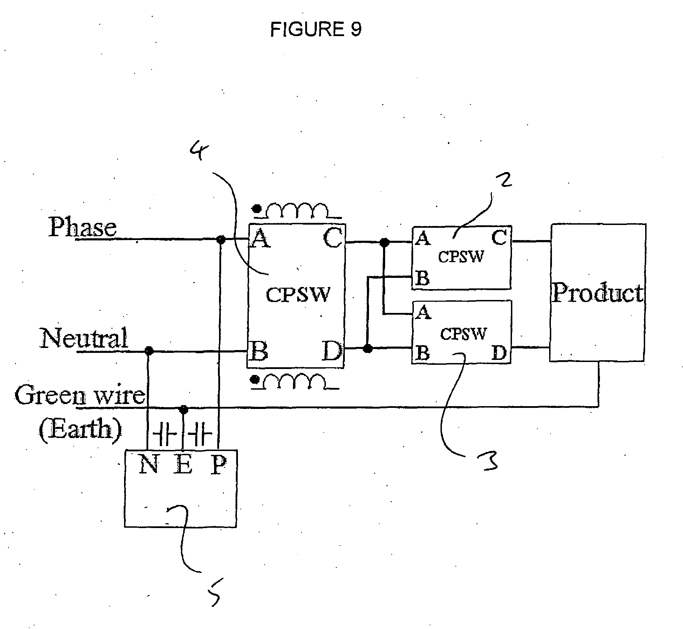

Viewed in the direction of from the power source to the product, the combined filter of FIG.7 may be considered to have the structure CM choke + C + DM filter. FIG.8 shows a modification of the embodiment of FIG.7 in which instead of being provided between the CM and DM spiral windings, the planar capacitor 5 is instead provided between the DM filters the electrical product. This structure is therefore CM choke + DM filter + C. A further possibility is the sequence C + CM choke + DM filter as shown in FIG.9 where the planar capacitor is located between the power source and the CM choke.

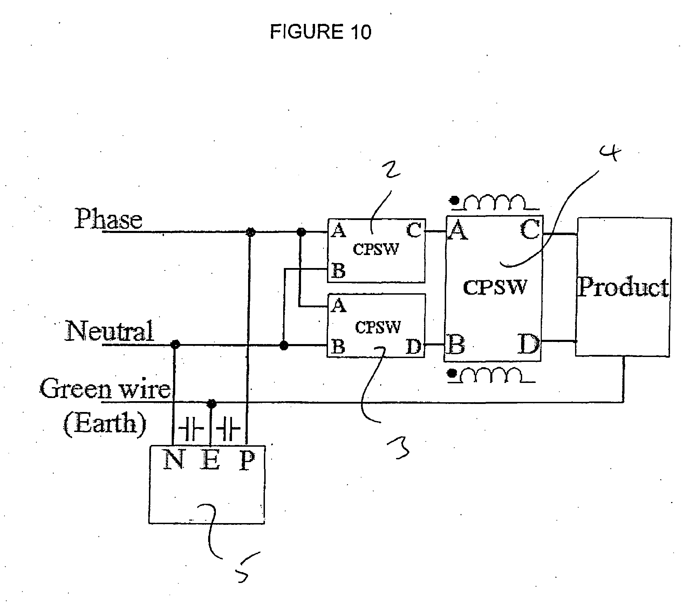

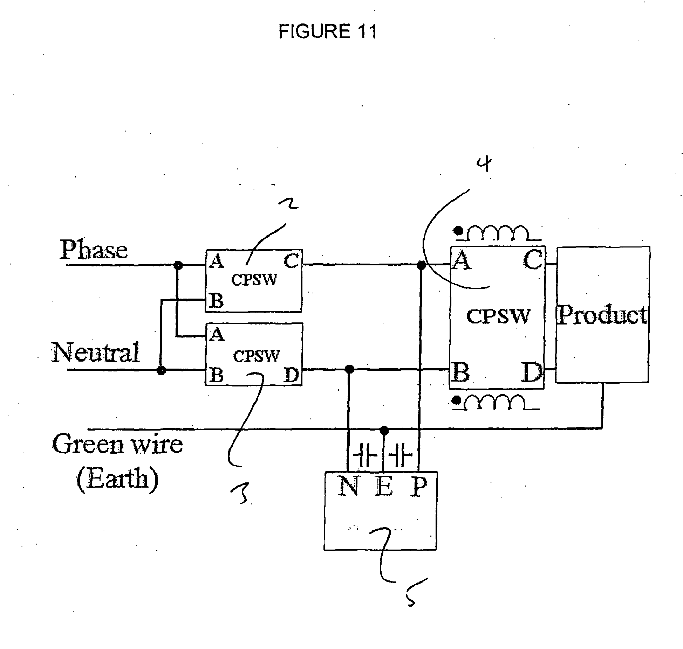

It is also possible for the DM filters to be located on the source side and the CM choke to be located on the product side. This possibility is shown in the embodiments of FIGS. 10 to 12 which differ in terms of location of the planar capacitor. FIG.10 has the structure C + DM filter + CM choke with the planar capacitor being located between the power source and the DM filter. In FIG.11 the planar capacitor is located between the DM filter and the CM choke, ie DM filter + C + CM choke, while finally in FIG.12 the planar capacitor is located between the CM choke and the product, ie the structure is DM filter + CM choke + C.

It should be noted that a stacked spiral winding structure can be used for the planar windings in which the winding structure comprises turns alternately on both sides of the substrate as shown in FIG.13. In such a structure a first winding starts from the centre of the spiral, and after the first loop the winding passes through the substrate by means of a via such that the second loop is on the opposite side of the substrate from the first. After the second loop the winding returns by means of another via to the first side of the substrate and the winding thus alternates between the two sides of the substrate. The second winding starts on the opposite side of the substrate from the first winding and like the first winding alternates from side of the substrate to the other. The advantage of this structure is that it greatly reduces the stray capacitance of the inductor which can consequently significantly increase the bandwidth. Such a structure may be particularly useful in power converters operating in the mega Hertz switching frequency range.

The planar EMI filter of embodiments of the present invention may also advantageously be used in combination with an active filter to provide effective noise suppression over a very wide bandwidth. Four basic types of active EMI filters have been proposed (Thomas Farkas and Martin F. Schlecht, "Viability of Active EMI Filters for Utility Applications", IEEE Transactions on Power Electronics, Vol.9, No.3, May 1994, pp.328-336; David C. Hamili, "An Efficient Active Ripple Filter for Use in DC-DC Conversion", IEEE Transactions on Aerospace and Electronic Systems, Vol.32, No.3, July 1996, pp.1077-1084; N.K.Poon, J.C.P. Liu, C.K. Tse, and M.H. Pong, "Techniques for Input Ripple Current Cancellation: Classification and Implementation", IEEE Transactions on Power Electronics, Vo1.15, No.6, November 2000, pp.1144-1152) and in the following embodiment an active filter in the form of a voltage feed-forward sensing and active coupling active filter will be used. In this embodiment the active filter consists of an operational amplifier and two shunt capacitors *C_{f}* and *Cₒ* connected at both the input and output of the operational amplifier as shown in FIG.14(a). For the sake of simplicity in the following discussion, the active filter is treated as a building block with terminals F and G as shown in FIG.14(b) where port G is always connected to ground.

FIG. 15 is a schematic view illustrating how a hybrid passive and active integrated EMI filter may be constructed. In FIG. 15 the blocks labeled "P" comprises planar EMI filters in accordance with embodiments of the invention, while blocks labeled "Q" comprise active filter blocks as shown in FIG.14(b). FIG.15 shows several possible locations for the active components which may be located at the middle-stage, the end-stage or both the middle- and end-stages of the planar EMI filter. Different locations of the active filter(s) will create different configurations for the EMI filter as shown in the following table:

| Filter | Description | Building Blocks |
|---|---|---|
| EMI Filter I (passive filter) | Coreless planar spiral winding (CPSW) based EMI filter | P1 + P2 + P3 |
| EMI Filter II (active filter) | Single-stage active filter | Q3 + Q4 |
| EMI Filter III (hybrid filter-1) | CPSW based + middle-stage active filter | P1 + P2 + P3 + Q1 + Q2 |
| EMI Filter IV (hybrid filter-2) | CPSW based + end-stage active filter | P1 + P2 + P3 + Q3 + Q4 |
| EMI Filter V (hybrid filter-3) | CPSW based + two-stage active filter | P1 + P2 + P3 + Q1 + Q2 + Q3 + Q4 |

The performance of such a hybrid EMI filter may be considered by looking at performance characteristics such as the insertion loss and measured transfer gain. FIG. 16 shows the simulated results of common-mode insertion-loss performances of the EMI filter I to EMI filter V (as defined in the table above). These results indicate that a simple passive CPSW based filter (Filter I) can have high insertion loss ability beyond 10MHz. The 1-stage active filter (Filter II) has a high insertion loss at the relatively low frequency range (from kHz to 10 MHz) but lower insertion loss than Filter I beyond 10MHz. For the three hybrid integrated filters, the presence of active blocks can boost up insertion loss of the CPSW based filter at low end frequency region (below MHz) significantly so that Filters III to V can achieve good insertion losses over a wide bandwidth for EMI reduction.

Measurements of the common-mode transfer gains for different filter configurations have been obtained and plotted in FIG.17. The results are obtained with the use of impedance/Gain-Phase analyzer, HP 4194A. The common-mode plot in FIG. 17 shows that the CPSW based filter can attenuate noise at high frequency range beyond 10MHz region. The active filter offers good noise suppression below 5MHz, but it does not improves at the high frequency range. However, with the combined use of active filter and the CPSW based filter, the three hybrid filters enjoy the advantages of the active and passive filters. They offer good noise attenuation at low and high frequency range up to 30MHz.

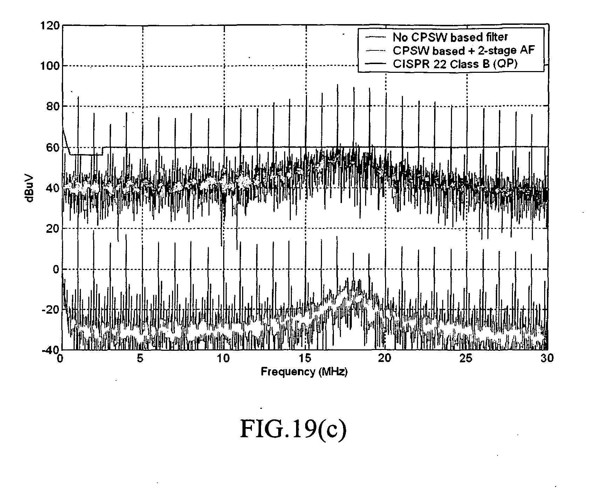

The different filter configurations considered in the above Table can also be put into an EMI simulation model emulating a 20W converter running at 1MHz with differential-mode noise generated by an input current source flowing through the input bulk capacitor's equivalent series resistance (ESR). The common-mode noise generation is more complicated and is based on the concept of non-contact coupling paths due to capacitive and inductance coupling. The use of non-contact coupling for common-mode noise would make the model be more realistic. FIG.18 shows the complete simulation schematic with different filter types (Filter I to Filter V) having been simulated one by one. FIGS.19(a), 19(b) and 19(c) show the simulated results in which FIG.19(a) shows simulated noise for "no filter" (uppermost plot in the figure), "Filter I" (middle plot) and "Filter III" (lowest plot in the figure) (150kHz-30MHz), FIG.19(b) shows simulated EMI noise for "Filter IT' (uppermost plot), "Filter IV' (middle plot) and "Filter V" (lowest plot) (150kHz-30MHz), and FIG.19(c) shows simulated EMI noise for "no filter" (upper plot) and "Filter V" (lower plot) (150kHz-30MHz).

For Filter I (CPSW based filter), the noise level has exceeded the CISPR Class B Limit at the low end of the spectrum. However, with a filter inductance of only a few micro-Henrys, it has attained good filtering capability at the high end of the spectrum. Filter III (CPSW passive + middle-stage active) and Filter IV (CPSW passive + end-stage active) show comparable results which further reduce the noise level of Filter I by 20 to 40 dBµV. These two types of filter configurations still cannot pass the CISPR Class B limit. This can be explained by the fact that some non-contact coupling paths have bypassed the input EMI filter. Even though the filters are of hybrid configurations, the common-mode noise is dominant and cannot be eliminated. Filter V (CPSW passive + 2-stage active) has the best filtering performance, reducing the noise level by 20 to 60 dBµV and passing the CISPR Class B limit line in the entire frequency range. It should be noted that the addition of one more stage of active filter at the input can effectively suppress the common-mode noise coming out from the converter due to both contact or non-contact coupling paths.

It will be seen from the above examples that even though the inductance of CPSW is of a few micro-henries only, it is large enough to perform the passive filtering function at the medium and high frequency range. It can also be seen that the addition of an active filter offers good noise attenuation at the relatively low frequency range, whilst the passive CPSW based filter can block high frequency noise. The hybrid EMI filter concept combines the advantages of the active and passive filters and consequently provides good filtering effect over a wide frequency range. The CPSW based passive filter alone may not pass the CISPR 22 Class B limit line in a 20W converter simulation, but with the addition of 1-stage active filter (end-stage or middle-stage), the filtering performance can reduce noise level by several tens of dBfµV while adding 2-stage active filtering onto the CPSW based filter can achieve the best performance and the overall system can pass the EMC limit line. In conclusion, the proposed hybrid EMI filter offers an effective filtering function over a very wide (30MHz) bandwidth. Such hybrid filter will provide an effective EMI filtering solution to future power converters switching above MegaHertz level.

## Claims

1. An EMI filter for use between a power source and an electronic product, said EMI filter comprising at least one planar element comprising a pair of opposed coreless spiral planar windings, and a planar capacitor.

2. A filter as claimed in claim 1 wherein said planar windings are formed on opposed sides of a substrate.

3. A filter as claimed in claim 2 wherein said substrate is a printed circuit board.

4. A filter as claimed in claim 1 wherein said planar capacitor comprises at least two parallel conductive plates spaced apart by a dielectric material.

5. A filter as claimed in claim 1 wherein said filter is a combined conductive mode filter and differential mode filter.

6. A filter as claimed in claim 1 wherein said conductive mode filter comprises a first said planar element, and wherein said differential mode filter comprises two said planar elements symmetrically disposed in the phase and neutral lines between the power source and the product.

7. A filter as claimed in claim 6 wherein said common mode filter is provided adjacent the power source and the differential mode filter is provided adjacent the product.

8. A filter as claimed in claim 7 wherein the planar capacitor is provided between the common mode filter and the differential mode filter.

9. A filter as claimed in claim 7 wherein the planar capacitor is provided between the differential mode filter and the product.

10. A filter as claimed in claim 7 wherein the planar capacitor is provided between the power source and the common mode filter.

11. A filter as claimed in claim 6 wherein the differential mode filter is provided adjacent to the power source and the common mode filter is provided adjacent to the product.

12. A filter as claimed in claim 11 wherein the planar capacitor is provided between the power source and the differential mode filter.

13. A filter as claimed in claim 11 wherein the planar capacitor is provided between the differential mode filter and the common mode filter.

14. A filter as claimed in claim 11 wherein the planar capacitor is provided between the common mode filter and the product.

15. A filter as claimed in claim 1 wherein said planar windings are formed such that alternate rings of each said spiral winding are formed on opposite sides of a substrate and are electrically interconnected by vias whereby each said side of the substrate is formed with alternating rings belong to said respective spiral windings.

16. A filter as claimed in claim 1 further comprising an active filter element.

17. A filter as claimed in claim 16 wherein the active filter is provided at the middle-stage, at the end-stage or at both the middle- and end-stage of said filter.

18. An EMI filter comprising a passive filter and an active filter wherein said passive filter comprises at least one planar element comprising a pair of opposed coreless spiral planar windings, and a planar capacitor.

19. A filter as claimed in claim 18 wherein the active filter is provided at the middle-stage, at the end-stage or at both the middle- and end-stage of said filter
